# EUROPÄISCHE PATENTSCHRIFT

(11) **EP 3 485 707 B1**
(45) Veröffentlichungstag und Bekanntmachung des Hinweises auf die Patenterteilung: **07.04.2021**
(21) Anmeldenummer: 17737793.4
(22) Anmeldetag: 11.07.2017
(51) Int. Cl.: H05K 1/02, H05K 3/22, H01H 37/76, H05K 3/30, H05K 3/34

(54) **ELEKTRONISCHE BAUGRUPPE MIT THERMOSICHERUNG**
ELECTRONIC ASSEMBLY WITH THERMAL FUSE
ENSEMBLE ÉLECTRONIQUE AVEC THERMOFUSIBLE

(30) Priorität: 15.07.2016 DE 102016213019
(43) Veröffentlichungstag der Anmeldung: 22.05.2019
(60) Teilanmeldung: 19200683.1
(73) Patentinhaber: Brose Fahrzeugteile SE & Co. Kommanditgesellschaft, Würzburg, 97076 Würzburg (DE)
(72) Erfinder: MARKERT, Matthias, 97437 Haßfurt (DE); BÖHM, Markus, 96199 Zapfendorf (DE)
(74) Vertreter: FDST Patentanwälte
(86) Internationale Anmeldenummer: PCT/EP2017/067380
(87) Internationale Veröffentlichungsnummer: WO 2018/011195

(56) Entgegenhaltungen:
- DE-A1-102009 046 489
- DE-A1-102010 003 241
- DE-A1-102014 111 772
- KR-B1- 101 505 865
- US-A1- 2011 050 386

## Beschreibung

Die Erfindung betrifft eine elektronische Baugruppe, insbesondere für einen Elektromotor eines Verstellsystems in einem Kraftfahrzeug, mit einer Leiterplatte, die eine stromführende Strombahn mit zwei zueinander beabstandeten Strombahnenden aufweist, die eine Unterbrechungsstelle bilden, die mittels eines einteiligen Kontaktbügels als Thermosicherung gebrückt ist.

Elektromotorisch betriebene Verstellsysteme als Kraftfahrzeugkomponenten, wie beispielsweise Fensterheber, Sitzverstellungen, Tür- und Schiebedachantriebe oder Kühlerlüfterantriebe weisen typischerweise einen gesteuerten Elektromotor auf. Zum Beispiel sind hierfür bürstenlose Elektromotoren bekannt, bei denen ein gegenüber einem Stator drehbar gelagerter Rotor durch ein magnetisches Drehfeld angetrieben wird. Hierzu werden Phasenwicklungen des Stators mit einem entsprechenden elektrischen Dreh- oder Motorstrom beaufschlagt, welcher mittels einer (Motor-)Elektronik als elektronische Baugruppe gesteuert und geregelt wird.

Die elektronische Baugruppe umfasst typischerweise eine elektronische Steuereinheit (Elektronik), welche häufig eine federbelastete Thermosicherung in Form einer Lötstelle oder-verbindung als Überlastschutz aufweist. Bei einem über eine bestimmte Zeit fließenden Überlaststrom tritt eine Wärmeentwicklung an der Lötstelle auf. In der Folge wird das Lot der Lötstelle aufgeschmolzen, so dass aufgrund der Federspannung der Thermosicherung die Leiterbahn spontan unterbrochen wird.

Aus der DE 10 2005 014 601 A1 ist eine elektronische Baugruppe der eingangsgenannten Art mit einem Kontaktbügel mit mehrfach gebogener, offener Bügelschlaufe bekannt, wobei der Kontaktbügel einen ersten und einen zweiten Kontaktschenkel aufweist, welche unter Verwendung von Lot mit den Strombahnenden kontaktiert sind. Einer der Kontaktschenkel sitzt in nicht näher angegebener oder beschriebener Weise in einer Leiterplattenöffnung ein. Im Anschluss an eine vorspannungslose Leiterplattenmontage wird der Kontaktbügel zur Erzeugung oder Herstellung einer inneren (mechanischen) Vorspannung verformt.

Bei einem thermischen Ereignis, beispielsweise in Folge eines Überstroms oder einer Temperaturerhöhung in der Umgebung, schmilzt das Lot zwischen der Leiterplatte und dem Kontaktbügel auf und dieser geht in seine entspannte Lage über. Hierdurch wird die Stromzufuhr in der Elektronik zu den Bauelementen oder Bauteilen unterbrochen. Es kann bei der bekannten Thermosicherung jedoch nicht sichergestellt und damit nicht ausgeschlossen werden, dass bei bestimmten thermischen Ereignissen und/oder bei einem ungünstigen Wärmeeinfluss die Lotverbindung des ersten oder auch des zweiten Kontaktschenkels des Kontaktbügels aufschmilzt und dieser somit keine ausreichende Fixierung mit der Leiterplatte eingeht beziehungsweise eine unkontrollierte Lage einnimmt.

Die US 2011/0050386 A1 beschreibt eine Thermosicherung mit einem Kontaktbügel, welcher einen mit den Strombahnen lotverbundenen Kontaktschenkel und einen in eine Leiterplattenöffnung eingreifenden Fixierschenkel aufweist. Der Kontaktschenkel und der Fixierschenkel sind mittels einer Bügelschlaufe verbunden, welche zur Erzeugung einer Vorspannung verformt ist.

In der DE 10 2009 046 489 A1 ist eine Thermosicherung offenbart, bei welchem ein Fixierschenkel eines vorgespannten Kontaktbügels kraft- oder formschlüssig mit einer Leiterplatte verbunden ist.

Die KR 101505865 B1 beschreibt eine Thermosicherung, bei welcher ein Fixierschenkel eines vorgespannten Kontaktbügels in eine Leiterplattenöffnung eingepresst ist.

Der Erfindung liegt die Aufgabe zugrunde, eine elektronische Baugruppe (Steuereinheit) mit einer besonders geeigneten, insbesondere auch in einfacher Art und Weise montierbare, Thermosicherung anzugeben. Insbesondere soll deren Kontaktbügel auch im Falle einer thermischen Auslösung stets eine kontrollierte Lage auf der Leiterplatte beibehalten.

Diese Aufgabe wird erfindungsgemäß gelöst mit den Merkmalen des Anspruchs 1. Vorteilhafte Ausgestaltungen und Weiterbildungen sind Gegenstand der Unteransprüche.

Hierzu umfasst die elektronische Baugruppe (elektronische Steuereinheit, Elektronik), insbesondere eines Elektromotors oder für einen solchen, eine Leiterplatte mit einer zwei zueinander beabstandete Strombahnenden aufweisenden (stromführen) Strombahn. Zwischen den Strombahnenden ist eine Unterbrechungsstelle gebildet, die mittels eines Kontaktbügels als Thermosicherung gebrückt ist. Der Kontaktbügel ist geeigneterweise ein Stanz-Biegeteil, das vorzugsweise spannungslos gefertigt ist. Als Basismaterial eignet sich besonders ein Kupferwerkstoff mit einer Zinn-Beschichtung für den Lötprozess mit der Leiterplatte in SMD-Technik (Surface Mounted Device).

Der Kontaktbügel weist eine mehrfach gebogene, zur Leiterplatte hin offene Bügelschlaufe sowie einen Kontaktschenkel und einen Fixierschenkel auf. Der Kontaktschenkel ist mit beiden Strombahnenden unter Verwendung von Lot kontaktiert, wobei die Strombahnenden vorzugsweise mit einem Lotpad versehen oder beschichtet sind. Der Fixierschenkel, der vorzugsweise mit keinem der Strombahnenden kontaktiert ist, weist ein in einer Leiterplattenöffnung einsitzendes Schenkelende sowie einen S-förmig aufgebogenen Schenkelabschnitt auf. Zusätzlich kann der Fixierschenkel in der Endmontage ebenfalls mittels Lot auf der Leiterplatte fixiert sein. Das Schenkelende des Fixierschenkels weist ein Übermaß gegenüber der Leiterplattenöffnung auf und dient im Zuge der Montage zur Lageorientierung des Kontaktbügels und damit der Thermosicherung auf der Leiterplatte. Im Zuge der Montage wird dem Kontaktbügel unter Erzeugung beziehungsweise Herstellung einer inneren Vorspannung (Federvorspannung) eine Verformung aufgeprägt, wobei vorzugsweise gleichzeitig das Schenkelende des Fixierschenkel in die Leiterplattenöffnung eingepresst wird und somit bei der Endmontage darin, insbesondere nach Art eines Press-Fit, eingepresst ist, wenn der Kontaktbügel in Folge dessen Verformung vorgespannt (worden) ist.

Das Schenkelende ist zur Bildung des Übermaßes gegenüber der Leiterplattenöffnung beispielsweise nach Art des Press-Fits oder nach Art einer stumpfen Pfeilspitze geometrisch ausgestaltet.

Der aufgebogene Schenkelabschnitt des Fixierschenkels bildet geeigneterweise eine An- oder Auflagefläche für ein die Verformung des Kontaktbügels erzeugendes Aktivierungswerkzeug.

Aufgrund der bevorzugten S-Form des Schenkelabschnitts ist eine besonders zweckmäßige An- oder Auflagefläche für das die Verformung des Kontaktbügels erzeugende Aktivierungswerkzeug gebildet, in dem dieses einerseits die Bügelschlaufe zur Herstellung der inneren Vorspannung des Kontaktbügels verformt und vorzugsweise zeitgleich das Schenkelende des Fixierschenkels unter gleichzeitiger Verformung des S-förmigen Schenkelabschnittes in die korrespondierende Leiterplattenöffnung einpresst.

Der Kontaktbügel weist unter Bildung der einseitig offenen Bügelschlaufe mehrere, vorzugsweise mindestens drei, weiter bevorzugt mindestens vier, Biegestellen auf. Eine dieser Biegestellen, welche bevorzugt im Bereich der dem Fixierschenkel zugewandten Schlaufenseite vorgesehen ist, dient quasi als Soll-Biegestelle für die Verformung des Kontaktbügels. Diese Soll-Biegestelle ist geeigneterweise zwischen einem aus der Leiterplatte empor ragenden Schlaufenteilabschnitt und einem ausgebogenen Schlaufenteilabschnitt der Bügelschlaufe gebildet.

Ein mittlerer Schlaufenabschnitt, der aus den mindestens drei Biegestellen und zwischen aufgebogenen sowie aus der Leiterplatte emporragenden Schlaufenabschnitten der Bügelschlaufe gebildet ist, überdeckt die Unterbrechungsstelle nicht, sondern befindet sich vorzugsweise neben dieser.

Im Auslösefall der Thermosicherung, wenn infolge einer entsprechenden Wärmeentwicklung das Lot aufschmilzt, hebt der Kontaktschenkel des Kontaktbügels aufgrund der Federrückstellkraft infolge der im Zuge der Verformung eingebrachten inneren Vorspannung spontan von der Leiterplatte und dort von beiden Strombahnenden ab, so dass die Strombahn besonders zuverlässig unterbrochen ist. Dabei besteht im Auslösefall einerseits keine kontaktierende Verbindung des Kontaktbügels mit der Strombahn bzw. dessen die Unterbrechungsstelle flankierenden Strombahnenden mehr. Andererseits ist aufgrund der mechanischen Fixierung des Fixierschenkels in der Leiterplatte bzw. in der entsprechenden Leiterplattenöffnung gleichzeitig sichergestellt, dass der Kontaktbügel keine undefinierte Lage einnimmt, da die für die Auslösung der Thermosicherung ursächliche Wärmeentwicklung praktisch keinen, die mechanische Verbindung des Kontaktbügels mit der Leiterplatte lösenden Einfluss hat.

Der mittlere Schlaufenabschnitt der Bügelschlaufe des Kontaktbügels weist geeigneterweise eine größere Abschnittsbreite als diejenige der aufgebogenen Schlaufenabschnitte beziehungsweise diejenige der Kontaktschenkel auf. Auf diese Weise ist es vorteilhaft ermöglicht, dass für unterschiedliche Stromtragfähigkeiten und/oder verschiedene Leistungsklassen quasi gleiche Stanz-Biege-Teile als Kontaktbügel verwendet werden können. Dabei ist lediglich der Kontaktschenkel, welcher die Unterbrechungsstelle brückt, hinsichtlich dessen Stanzgeometrie in der Breite anzupassen (Querschnittsanpassung). Diese Anpassung kann über Werkzeugeinsätze im Stanz-Biege-Verbundwerkzeug erfolgen. Diese Variante hat dabei vorteilhafterweise keinen Einfluss auf die entsprechende Aktivierungsgeometrie, und die Stanzbreite des Kontaktbügels ist für alle Varianten gleich.

In geeigneter Ausgestaltung ist in den mittleren Schlaufenabschnitt der Bügelschlaufe eine, vorzugsweise langlochartige, Stanzöffnung eingebracht. Diese erstreckt sich zweckmäßigerweise mindestens über eine der drei Biegestellen des mittleren Schlaufenabschnitts. Besonders vorteilhaft erstreckt sich die Stanzöffnung ausgehend von etwa der Mitte des mittleren Schlaufenabschnitts in den sich an den Fixierschenkel anschließenden aufgebogenen und dort ausgebogenen Schlaufenteilabschnitt hinein. Hierdurch ist eine besonders vorteilhafte und insbesondere definierte Verformung des Kontaktbügels zur Erzeugung dessen innerer Vorspannung ermöglicht. Des Weiteren wird somit eine vergleichsweise bauraumreduzierte Thermosicherung erzeugt.

In besonders vorteilhafter Ausgestaltung weist der Fixierschenkel einen auf der Leiterplatte, insbesondere auf einem dortigen Lotpad, aufliegenden Anlageabschnitt und den S-förmig aufgebogenen Schenkelabschnitt auf. Dieser weist eine gegenüber dem Anlageabschnitt verringerte Abschnittsbreite auf, wobei das Abschnittsende des S-förmig aufgebogenen Schenkelabschnitts das in der Leiterplattenöffnung einsitzende Schenkelende des Fixierschenkels bildet.

Die mit der Erfindung erzielten Vorteile bestehen insbesondere darin, dass mittels einer einteiligen Kontaktbügels als Thermosicherung für eine elektronische Baugruppe eine Fixierung als SMD-Bauelement ohne zusätzliche Einzelkomponenten ermöglicht ist. Sowohl die Fixierung des Kontaktbügels auf der Leiterplatte als auch die Aktivierung des Kontaktbügels durch dessen Verformung zur Herstellung der inneren Federvorspannung erfolgt aus der gleichen Montagerichtung. Zudem ist die derart realisierte Thermosicherung besonders bauraum- und kostensparend. Die Realisierung unterschiedlicher Leistungsklassen ist in einem Werkzeug ermöglicht, wobei die entsprechende Varianz in der Breite des Kontaktschenkels des Kontaktbügels mittels Werkzeugeinsätzen realisierbar ist.

Besonders vorteilhaft ist einerseits die zuverlässige Lageorientierung des Kontaktbügels bereits im Zuge der Leiterplattenmontage. Andererseits ist nach erfolgter Montage mit Presssitz des Schenkelendes des Fixierschenkels in der korrespondierenden Leiterplattenöffnung eine besonders zuverlässige mechanische Lagefixierung der Thermosicherung unabhängig von thermischen Einflüssen erreicht.

Die Montage des Kontaktbügels und damit der Thermosicherung inklusive deren Aktivierung durch Erzeugung der inneren Vorspannung des Kontaktbügels kann besonders vorteilhaft mittels des selben Aktivierungswerkzeugs erfolgen, indem dieses sowohl an der Bügelschlaufe zur Verformung des Kontaktbügels als auch am Schenkelende des Fixierschenkels zur Herstellung dessen Presssitzes in der Leiterplattenöffnung vorgesehen und eingesetzt werden kann. Die zuverlässige Fixierung des Kontaktbügels mittels des Schenkelendes des Fixierschenkels ist darüber hinaus einfach realisiert, indem dieses, zur Herstellung einer Presspassung dienende Schenkelende geeigneterweise Bestandteil des Kontaktbügels ist. Dabei ist der vorteilhafterweise S-förmige Schenkelabschnitt geeigneterweise stoffschlüssig mit dem Fixierschenkel verbunden und somit ebenfalls einteiliger Bestandteil des vorzugsweise als Stanz-Biege-Teil hergestellten Kontaktbügels.

Nachfolgend sind Ausführungsbeispiele der Erfindung anhand einer Zeichnung näher erläutert. Darin zeigen:
- Fig. 1: ausschnittsweise in perspektivischer Darstellung eine elektronische Baugruppe mit einer Leiterplatte , die eine stromführende Strombahn mit zwei zueinander beabstandeten Strombahnenden aufweist, die eine Unterbrechungsstelle bilden, die mittels eines einteiligen Kontaktbügels als Thermosicherung gebrückt ist,
- Fig. 2: in einer Darstellung gemäß Fig. 1 den Kontaktbügel in einem verformten und gespannten Zustand,
- Fig. 3: in einer Darstellung gemäß Fig. 1 den Kontaktbügel in einem ausgelösten Zustand der Thermosicherung,
- Fig. 4: in einer vergrößerten Ausschnittsdarstellung einen Fixierschenkel des Kontaktbügels zur Presssitz-Befestigung (Press-Fit-Befestigung) in einer Leiterplattenöffnung der Leiterplatte,
- Fig. 5 bis 8: in Seitenansicht die Verformung und Vorspannung des Kontaktbügels,
- Fig. 9: in einer Darstellung gemäß Fig. 4 eine erste alternative Ausgestaltung des Fixierschenkels,
- Fig. 10: in einer perspektivischen Darstellung die Baugruppe mit einer zweiten alternativen Ausgestaltung des Fixierschenkels, und
- Fig. 11: in einer perspektivischen Darstellung die Baugruppe mit einer dritten alternativen Ausgestaltung des Fixierschenkels.

Einander entsprechende Teile und Größen sind in allen Figuren stets mit den gleichen Bezugszeichen versehen.

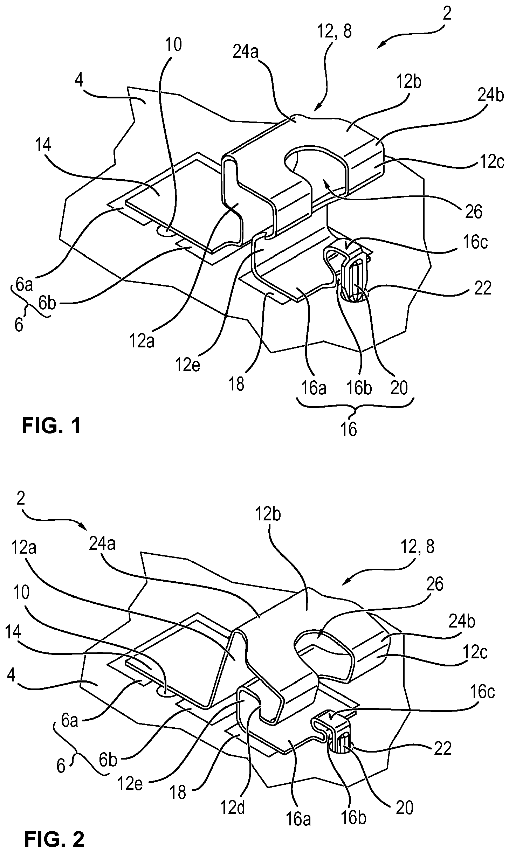

Fig. 1 zeigt ausschnittsweise eine elektronische Baugruppe 2 eines nicht näher dargestellten Elektromotors für einen Verstellantrieb eines Kraftfahrzeugs. Die Baugruppe 2 umfasst eine mit (nicht dargestellten) elektrischen Bauteilen bestückte Leiterplatte 4 mit einer ausschnittsweise dargestellten Strombahn 6. Die Strombahn 6 weist weiterhin eine Thermosicherung 8 auf. Die Thermosicherung 8 schützt den Elektromotor im Betrieb vor einer Überhitzung und Brandgefahr. Überhitzt der Elektromotor, so wird die Thermosicherung 8 ausgelöst und dadurch der Stromfluss zu dem Elektromotor unterbrochen.

Die Thermosicherung 8 verbindet den Motorstrom führende Strombahnenden 6a und 6b über eine Unterbrechungsstelle 10 der Strombahn 6 miteinander. In dem Ausführungsbeispiel der Fig. 1 ist die Unterbrechungsstelle 10 insbesondere durch eine langlochartige Aussparung der Leiterplatte 4 zwischen den Strombahnenden 6a und 6b gebildet. Die Thermosicherung 8 ist als ein Kontaktbügel ausgeführt und nachfolgend auch als solcher bezeichnet.

Der Kontaktbügel 8 ist ein Stanz-Biegeteil mit einer mehrfach gebogenen, offenen Bügelschlaufe 12, welche schlaufenendseitig einerseits mit einem Kontaktschenkel 14 und andererseits mit einem Fixierschenkel 16 ausgeführt ist. Wie in den Figuren 1 bis 3 vergleichsweise deutlich ersichtlich ist, übergreift der Kontaktschenkel 14 brückenartig die Unterbrechungsstelle 10. Mit anderen Worten wird die Unterbrechungsstelle 10 zwischen den Strombahnenden 6a und 6b lediglich mit dem Kontaktschenkel 14 überbrückt.

Im (unausgelösten) Montagezustand ist der laschenartige Kontaktschenkel 14 mittels jeweils einer Lotverbindung an dem Strombahnende 6a einerseits und an dem Strombahnende 6b andererseits befestigt. Die dadurch gebildeten Lötstellen kontaktieren die Strombahnenden 6a und 6b elektrisch über den Kontaktschenkel 14 und verbinden den Kontaktschenkel 14 mechanisch mit der Leiterplatte 4.

Der Kontaktbügel 8 ist vorzugsweise vorspannungslos aus einem Kupfermaterial mit einer Zinn-Beschichtung hergestellt, sodass die Lötverbindungen des Kontaktschenkels 14 mit den Strombahnenden 6a und 6b insbesondere in SMD-Technik herstellbar sind. Die Dimensionierung der Schenkel- oder Abschnittsbreite des Kontaktschenkels 14 ist hierbei an die im Normalbetrieb auftretende Stromstärke des Motorstroms angepasst. Dies bedeutet, dass die joulesche Wärmeentwicklung des Kontaktschenkels 14 im Normalbetrieb nicht ausreichend ist, um die Lötstellen zwischen den Strombahnenden 6a und 6b aufzuschmelzen.

Zur Realisierung der Sicherungsfunktion des Kontaktbügels 8 ist im Anschluss an eine vorspannungslose Leiterplattenmontage eine Verformung des Kontaktbügels 8 zur Erzeugung oder Herstellung einer inneren (mechanischen) Vorspannung vorgesehen (Fig. 2).

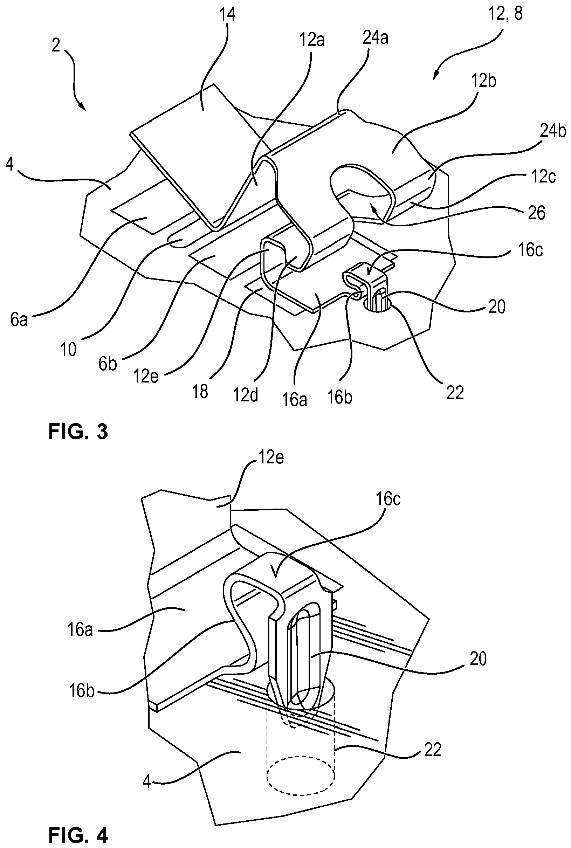

Der Kontaktbügel 8 ist im Montagezustand mittels des Fixierschenkels 16 mechanisch mittels einer Lötverbindung an ein Lotpad 18 angebunden. Des Weiteren weist der Fixierschenkel 16 ein zungenartiges Schenkelende 20 auf. Das in Fig. 4 näher dargestellte Schenkelende 20 ist zur Befestigung des Kontaktbügels 8 an der Leiterplatte 4 in eine zylindrische Leiterplattenöffnung 22 einführbar. Das Schenkelende 20 weist hierbei eine Schenkelbreite auf, welche in Bezug auf den Durchmesser der Leiterplattenöffnung 22 zumindest abschnittsweise in einem Übermaß hergestellt ist. Zur Befestigung wird das Schenkelende 20 in die Leiterplattenöffnung 22 eingepresst.

In einem Auslösefall, bei welchem sowohl die Lötstellen zwischen den Strombahnenden 6a und 6b und dem Kontaktschenkel 14 sowie die Lötstelle zwischen dem Lotpad 18 und dem Fixierschenkel 16 aufgrund einer Wärmeentwicklung aufgeschmolzen ist, wird der Kontaktschenkel 14 aufgrund der Vorspannung des Kontaktbügels 8 in eine nicht kontaktierende Stellung verschwenkt (Fig. 3). Durch die mechanische Fixierung mittels des Schenkelendes 20 ist hierbei sichergestellt, dass der Kontaktbügel 8 auch im Auslösefall stets in einer definierten Lage auf der Leiterplatte 4 gehalten ist.

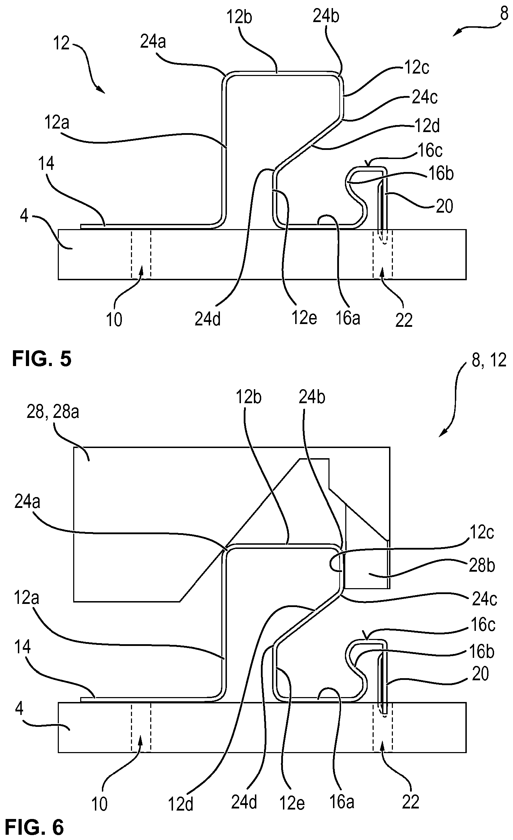

Nachfolgend ist die Montage des Kontaktbügels 8 anhand der Figuren 5 bis 8 näher erläutert.

Wie in den Seitendarstellungen der Fig. 5 bis Fig. 8 vergleichsweise deutlich ersichtlich ist, weist der Kontaktbügel 8 in diesem Ausführungsbeispiel unter Bildung der Bügelschlaufe 12 im Wesentlichen vier Biegestellen 24a, 24b, 24c, und 24d auf. Durch die Biegestellen 24a, 24b, 24c, und 24d werden im Wesentlichen fünf Teilabschnitte der Bügelschlaufe 12, nachfolgend auch als Schlaufenabschnitte 12a, 12b, 12c, 12d und 12e bezeichnet, gebildet. Der Schlaufenabschnitt 12a geht hierbei einstückig oder monolithisch in den Kontaktschenkel 14 und der Schlaufenabschnitt 12e einstückig oder monolithisch in den Fixierschenkel 16 über. Die Bügelschlaufe 12 weist in diese Übergangsbereichen jeweils eine nicht näher bezeichnete Biegestelle auf, mittels welchen die Bügelschlaufe 12 der Leiterplatte 4 im Wesentlichen emporsteht.

In dem in Fig. 5 dargestellten, ungespannten Zustand des Kontaktbügels 8 sind die Schlaufenabschnitte 12a und 12e im Wesentlichen senkrecht zur Leiterplatte 4 orientiert. Die Schlaufenabschnitte 12a und 12e sind parallel und beabstandet zueinander unter Bildung einer zur Leiterplatte 4 hin orientierten Schlaufenöffnung angeordnet. Der vergleichsweise lange Schlaufenabschnitt 12a ist mittels der im Wesentlichen rechtwinkeligen Biegestelle 24a in den Schlaufenabschnitt 12b überführt. Der Schlaufenabschnitt 12b ist hierbei parallel zur Leiterplatte 4 orientiert.

Die Biegestellte 24b zwischen dem Schlaufenabschnitt 12b und 12c weist einen im Wesentlichen rechtwinkeligen Biegewinkel auf. Dadurch ist der Schlaufenabschnitt 12c im Wesentlichen parallel zu den Schlaufenabschnitten 12a und 12e orientiert. Unter einem Biegewinkel ist nachfolgend insbesondere der Winkel der Biegung einer Biegestelle bezeichnet. Dies ist der eingeschlossene Winkel zwischen zwei benachbarten Schlaufenabschnitten, wobei insbesondere die Winkel innerhalb der Schlaufenkontur der Bügelschlaufe 12 als Biegewinkel bezeichnet sind.

Die Biegestelle 24c zwischen dem Schlaufenabschnitten 12c und 12d weist einen stumpfen Biegewinkel, also einen Biegewinkel zwischen 90° und 180° auf. Dadurch verläuft der Schlaufenabschnitt 12d in Bezug auf die Leiterplatte 4 geneigt oder schräg bis zu der Biegestelle 24d. Die Biegestelle 24d weist hierbei einen überstumpfen Biegewinkel auf, also einen Biegewinkel größer 180°.

Das Ausführungsbeispiel des Kontaktbügels 8 in den Figuren 1 bis 4 weist hierbei im Bereich des Schlaufenabschnittes 12d zwei zusätzliche, nicht näher bezeichnete Biegestellen auf, mit welchen im Zuge der Vorspannung ein stufenartiger Absatz als Soll-Biegestelle gebildet wird. Zusätzlich ist eine langlochartige Stanzöffnung 26 in die Bügelschlaufe 12 eingebracht. Wie insbesondere in den Figuren 1 bis 3 ersichtlich ist, erstreckt sich die Stanzöffnung 26 im Wesentlichen von dem Schlaufenabschnitt 12c über die Biegestelle 24b, den Schlaufenabschnitt 12d und die Biegestelle 24c zu dem Schlaufenabschnitt 12d.

Die Schlaufenabschnitte 12a und 12e bilden einen aufgebogenen Bereich der Bügelschlaufe 12, wobei die Schlaufenabschnitte 12b, 12c und 12d im Wesentlichen einen dazwischen angeordneten, mittleren Abschnitt oder Bereich der Bügelschlaufe 12 ausbilden. Dieser mittlere Abschnitt weist - wie in den Figuren 1 bis 3 ersichtlich - eine gegenüber dem Kontaktschenkel 14 und dem Fixierschenkel 16 verbreiterte Abschnittsbreite auf. Im Bereich dieser verbreiterten Abschnittsbreite ist die Stanzöffnung 26 eingebracht.

Der Fixierschenkel 16 weist einen am Lotpad 18 befestigten Anlageabschnitt 16a sowie einen aufgebogenen Schenkelabschnitt 16b auf. Der Schenkelabschnitt 16b weist - wie insbesondere in den Figuren 1 bis 4 dargestellt - eine gegenüber dem Anlageabschnitt 16a verringerte Abschnitts- oder Schenkelbreite auf. Der Schenkelabschnitt 16b geht freiendseitig in das Schenkelende 20 über. Der Schenkelabschnitt 16b weist hierbei eine im Wesentlichen S-förmige Biegekontur zwischen dem Anlageabschnitt 16a und dem Schenkelende 20 auf.

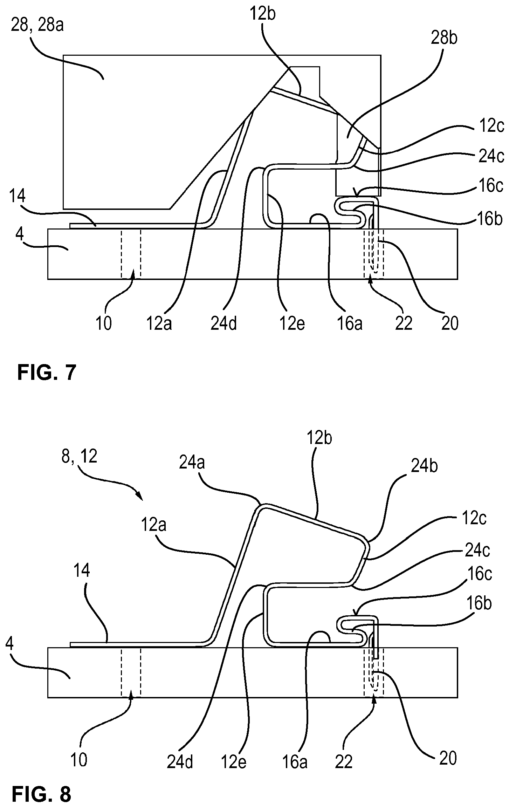

Im Zuge der Montage wird dem Kontaktbügel 8 unter Erzeugung beziehungsweise Herstellung einer inneren Vorspannung (Federvorspannung) mit einem Aktivierungswerkzeug beziehungsweise einem Stempel 28 eine Verformung aufgeprägt (Fig. 6, Fig. 7). Die Biegestelle 24d dient während der Verformung als eine Soll-Biegestelle des Kontaktbügels 8.

Wie in der Fig. 7 und Fig. 8 dargestellt, wird der Biegewinkel der Biegestellte 24d zu einem überstumpfen Winkel von etwa 270° gebogen, sodass der Schlaufenabschnitt 12d im Wesentlichen parallel zu der Leiterplatte 4 orientiert ist. Im Zuge der Verformung wird die Biegestelle zwischen dem Schlaufenabschnitt 12a und dem Kontaktschenkel 14 derart aufgebogen, dass der Schlaufenabschnitt 12a unter einem geneigten Winkel schräg gegenüber der Leiterplatte 4 verläuft.

Während des Verformungs- oder Vorspannungsprozesses wird, vorzugsweise zeitgleich, das Schenkelende 20 des Fixierschenkels 16 in die Leiterplattenöffnung 22 eingepresst und somit bei der Endmontage (Fig. 8) darin, insbesondere nach Art eines Press-Fit, befestigt. Hierzu drückt der Stempel 28 auf einen von der Leiterplatte 4 beabstandeten horizontalen S-Schenkel des Schenkelabschnitts 16b. Mit anderen Worten wirkt der horizontale S-Schenkel als eine An- oder Auflagefläche 16c für den Stempel 28. Der Stempel 28 verformt den Schenkelabschnitt 16b, sodass die S-förmige Kontur des Schenkelabschnitts 16b gestaucht beziehungsweise zusammengedrückt (Fig. 7) wird. Dadurch wird gleichzeitig das Schenkelende 20 in die Leiterplattenöffnung 22 eingepresst.

Für die Montage des Kontaktbügels 8 weist der Stempel 28 im Wesentlichen einen ersten Stempelbereich 28a für die Verformung und Vorspannung der Bügelschlaufe 12 und einen zweiten, fortsatzartigen Stempelbereich 28b zum Verformen des Fixierschenkels 16 und gleichzeitigen Einpressen des Schenkelendes 20 in die Leiterplattenöffnung 22 auf. Beim Verformen der Bügelschlaufe 12 wird diese derart gebogen, die Schlaufenabschnitte 12b, 12c und 12d zumindest abschnittsweise den Fixierschenkel 16 übergreifen. Die Stanzöffnung 26 dient hierbei als eine Aussparung für den Stempelbereich 28b, sodass dieser zuverlässig auf den Fixierschenkel 16 einwirkt. Mit anderen Worten liegt der Stempelbereich 28b in der Darstellung der Fig. 7 zumindest teilweise innerhalb der Stanzöffnung 26 des Bügelschenkels 12 ein. Dies bedeutet, dass die Stanzöffnung 26 als ein für die Montage vorteilhafter Freiraum für das Aktivierungswerkzeug 28 wirkt.

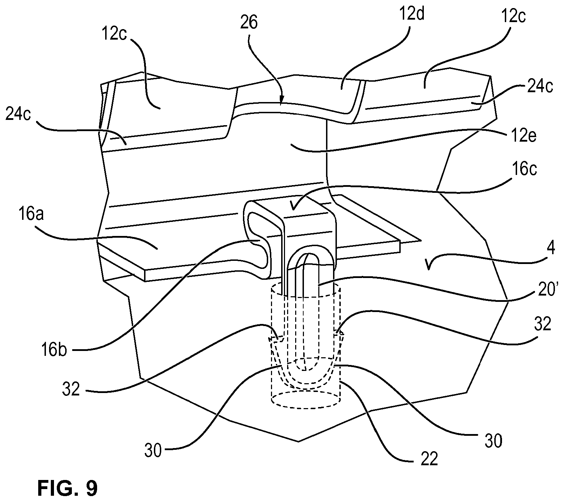

In dem Ausführungsbeispiel der Fig. 9 ist eine alternative Ausgestaltung des Fixierschenkels 16 beziehungsweise des Schenkelendes 20' im eingepressten Zustand innerhalb der Leiterplattenöffnung 22 dargestellt. In diesem Ausführungsbeispiel ist das Schenkelende 20' geometrisch im Wesentlichen als eine stumpfe Pfeilspitze ausgebildet. Das etwa blattspitzenartige Schenkelende 20' weist hierbei zwei geneigte Außenseiten oder Flügel 30 auf, welche von der stumpfen Spitze zu einer Spitzenbasis 32 verlaufen. Die Spitzenbasis 32 weist hierbei das Übermaß bezüglich der Leiterplattenöffnung 22 für die Press-Fit-Befestigung auf.

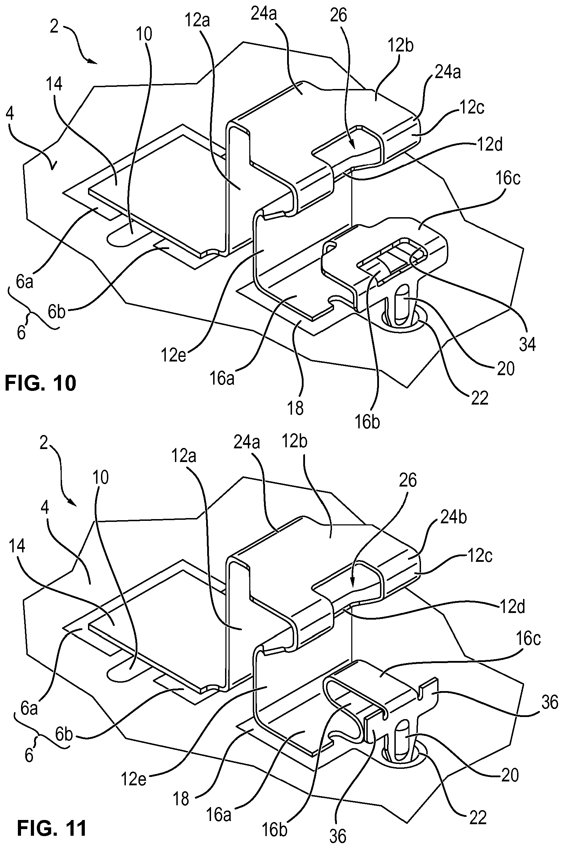

In den Figuren 10 und 11 sind zwei weitere Ausgestaltungsformen des Fixierschenkels 16 in einem teilmontierten Zustand des Kontaktbügels 8 gezeigt. In diesen Ausführungsbeispielen ist die Leiterplattenöffnung 22 von dem Lotpad 18 zumindest abschnittsweise eingefasst.

In dem Ausführungsbeispiel der Fig. 10 weist der Fixierschenkel 16 eine verbreiterte Anlagefläche 16c für den Stempelabschnitt 28a auf. Dadurch wird das Einpressen des Schenkelendes 20 in die Leiterplattenöffnung 22 vereinfacht. In die Anlagefläche 16c ist hierbei eine Stanzöffnung 34 eingebracht.

Das Ausführungsbeispiel der Fig. 11 zeigt einen Fixierschenkel 16 mit einem Schenkelende 20, welches im Bereich der Anlagefläche 16c zwei umfangsseitig überstehende Stanzlaschen 36 aufweist. Das Schenkelende 20 weist somit im Wesentlichen eine T-förmige Gestalt auf, wobei die Stanzlaschen 36 den horizontalen T-Schenkel und der in die Leitplattenöffnung 22 einpressbare Schaft den vertikalen T-Schenkel bilden. Die Stanzlaschen 36 verbessern den Krafteinfluss im Zuge der Einpressung in die Leiterplattenöffnung 22. Dadurch wird die Faltungseigenschaft des etwa S-förmigen Schenkelabschnitts 16b bei der Montage verbessert.

### Bezugszeichenliste

- 2: Baugruppe
- 4: Leiterplatte
- 6: Strombahn
- 6a, 6b: Strombahnende
- 8: Thermosicherung/Kontaktbügel
- 10: Unterbrechungsstelle
- 12: Bügelschlaufe
- 12a, 12b, 12c, 12d, 12e: Schlaufenabschnitt
- 14: Kontaktschenkel
- 16: Fixierschenkel
- 16a: Anlageabschnitt
- 16b: Schenkelabschnitt
- 16c: Anlagefläche, Auflagefläche
- 18: Lotpad
- 20,20': Schenkelende
- 22: Leiterplattenöffnung
- 24a, 24b, 24c, 24d: Biegestelle
- 26: Stanzöffnung
- 28: Aktivierungswerkzeug/Stempel
- 28a, 28b: Stempelbereich
- 30: Flügel/Außenseite
- 32: Spitzenbasis
- 34: Stanzöffnung
- 36: Stanzlasche

## Patentansprüche

1. Elektronische Baugruppe (2), insbesondere eines Elektromotors, mit einer Leiterplatte (4), die eine stromführende Strombahn (6) mit zwei zueinander beabstandeten Strombahnenden (6a, 6b) aufweist, die eine Unterbrechungsstelle (10) bilden, die mittels eines, insbesondere vorspannungslos gefertigten, Kontaktbügels (8) als Thermosicherung gebrückt ist,
- wobei der Kontaktbügel (8) eine mehrfach gebogene, offene Bügelschlaufe (12) sowie einen mit beiden Strombahnenden (6a, 6b) unter Verwendung von Lot kontaktierten Kontaktschenkel (14) und einen Fixierschenkel (16) mit einem in einer Leiterplattenöffnung (22) einsitzenden Schenkelende (20) aufweist, und
- wobei dem Kontaktbügel (8) unter Erzeugung einer inneren Vorspannung eine Verformung aufgeprägt ist,
**dadurch gekennzeichnet,**
- **dass** der Fixierschenkel (16) einen S-förmig aufgebogenen Schenkelabschnitt (16b) aufweist, und
- **dass** das Schenkelende (20) des Fixierschenkels (16) ein Übermaß gegenüber der Leiterplattenöffnung (22) aufweist.

2. Elektronische Baugruppe (2) nach Anspruch 1,
**dadurch gekennzeichnet,**
**dass** das Schenkelende (20) des Fixierschenkels (16) in die Leiterplattenöffnung (22) eingepresst ist, wenn der Kontaktbügel (8) infolge dessen Verformung vorgespannt ist.

3. Elektronische Baugruppe (2) nach Anspruch 1 oder 2,
**dadurch gekennzeichnet,**
**dass** die Bügelschlaufe (12) des Kontaktbügels (8) auf der dem Fixierschenkel (16) zugewandten Schlaufenseite einen unter Bildung einer Soll-Biegestelle (24d) für die Verformung des Kontaktbügels (8) ausgebogenen Schlaufenabschnitt (12d) aufweist.

4. Elektronische Baugruppe (2) nach einem der Ansprüche 1 bis 3,
**dadurch gekennzeichnet,**
**dass** zwischen dem Kontaktschenkel (14) und dem Fixierschenkel (16) aufgebogene Schlaufenabschnitte (12a, 12e) der Bügelschlaufe (12) des Kontaktbügels (8) und ein mittlerer Schlaufenabschnitt (12b, 12c, 12d) mit mindestens drei Biegestellen (24a, 24b, 24c, 24d) gebildet sind.

5. Elektronische Baugruppe (2) nach Anspruch 4,
**dadurch gekennzeichnet,**
**dass** der mittlere Schlaufenabschnitten (12b, 12c, 12d) der Bügelschlaufe (12) eine größere Abschnittsbreite aufweist als der Kontaktschenkel (14) und/oder der Fixierschenkel (16).

6. Elektronische Baugruppe (2) nach Anspruch 4 oder 5,
**dadurch gekennzeichnet,**
**dass** in den mittleren Schlaufenabschnitt (12b, 12c, 12d) der Bügelschlaufe (12) eine Stanzöffnung (26) eingebracht ist.

7. Elektronische Baugruppe (2) nach Anspruch 6,
**dadurch gekennzeichnet,**
**dass** sich die Stanzöffnung (26) über mindestens eine der drei Biegestellen (24b, 24c, 24d) des mittleren Schlaufenabschnitts (12b, 12c, 12d) erstreckt.

8. Elektronische Baugruppe (2) nach einem der Ansprüche 1 bis 7,
**dadurch gekennzeichnet,**
**dass** der Fixierschenkel (16) einen auf der Leiterplatte (4), insbesondere auf einem Lotpad (18), aufliegenden Anlageabschnitt (16a) und den aufgebogenen Schenkelabschnitt (16b) mit einer gegenüber dem Anlageabschnitt (16a) verringerten Abschnittsbreite aufweist, dessen Abschnittsende das in der Leiterplattenöffnung (22) einsitzende Schenkelende (20) bildet.

9. Elektronische Baugruppe (2) nach einem der Ansprüche 1 bis 8,
**dadurch gekennzeichnet,**
**dass** der S-förmig aufgebogenen Schenkelabschnitt (16b) des Fixierschenkels (16) eine An- oder Auflagefläche (16c) für ein die Verformung des Kontaktbügels (8) erzeugendes Aktivierungswerkzeug (28) bildet.

10. Verwendung einer elektronischen Baugruppe (2) nach einem der Ansprüche 1 bis 9 für einen Elektromotor eines Verstellsystems oder -antriebs eines Kraftfahrzeugs.

## Claims

1. Electronic assembly (2), in particular of an electric motor, with a printed circuit board (4) having a current-carrying current path (6) with two mutually spaced-apart current path ends (6a, 6b), said current path ends (6a, 6b) forming an interruption point (10), which is bridged as a thermal fuse by means of a contact clip (8), said contact clip (8) being produced in particular without a preload,
- wherein the contact clip (8) has a multiply bent, open clip loop (12) as well as a contact limb (14) contacted with both current path ends (6a, 6b) using solder, and a fixing limb (16) with a limb end (20), which is seated in a printed circuit board opening (22), and
- wherein a deformation is impressed on the contact limb (8) under generation of an internal preload.
**characterized in**
- **that** the fixing limb (16) has a limb section (16b) bent-up in an S-shape,
- **that** the limb end (20) of the fixing limb (16) has an oversize with respect to the printed circuit board opening (22).

2. Electronic assembly (2) according to claim 1,
**characterized in**
**that** the limb end (20) of the fixing limb (16) is pressed into the printed circuit board opening (22), when the contact clip (8) is preloaded as a result of being deformed.

3. Electronic assembly (2) according to claim 1 or 2,
**characterized in**
**that** the loop (12) of the contact clip (8) has, on the loop side facing the fixing limb (16), a loop section (12d) bent out to form a predetermined bending point (24d) for the deformation of the contact clip (8).

4. Electronic assembly (2) according to one of claims 1 to 3,
**characterized in**
**that** bent-up loop sections (12a, 12e) of the clip loop (12) of the contact clip (8) and a middle loop section (12b, 12c, 12d) with at least three bending points (24a, 24b, 24c, 24d) are formed between the contact limb (14) and the fixing limb (16).

5. Electronic assembly (2) according to claim 4,
**characterized in**
**that** the middle loop section (12b, 12c, 12d) of the clip loop (12) has a larger section width than the contact limb (14) and/or the fixing limb (16).

6. Electronic assembly (2) according to claim 4 or 5,
**characterized in**
**that** a punch opening (26) is inserted in the middle loop section (12b, 12c, 12d) of the clip loop (12).

7. Electronic assembly (2) according to claim 6,
**characterized in**
**that** the punch opening (26) extends over at least one of the three bending points (24b, 24c, 24d) of the middle loop section (12b, 12c, 12d).

8. Electronic assembly (2) according to one of claims 1 to 7,
**characterized in**
**that** the fixing limb (16) has an abutment section (16a) resting on the printed circuit board (4), in particular on a solder pad (18), and the bent-up limb section (16b) with a reduced section width relative to the abutment section (16a), whose section end forms the limb end (20) seated in the printed circuit board opening (22).

9. Electronic assembly (2) according to one of claims 1 to 8,
**characterized in**
**that** the S-shaped bent-up limb section (16b) of the fixing limb (16) forms an abutment or bearing surface (16c) for an activation tool (28), which generates the deformation of the contact clip (8).

10. Use of an electronic assembly (2) according to one of claims 1 to 9 for an electric motor of an adjustment system or drive of a motor vehicle.

## Revendications

1. Assemblage électronique (2), en particulier d'un moteur électrique, avec une carte de circuit imprimé (4) comprenant un trajet de courant (6) conducteur avec deux extrémités de trajet de courant (6a, 6b) espacées l'une de l'autre, les extrémités de trajet de courant (6a, 6b) formant un point d'interruption (10), qui est ponté en tant que fusible thermique au moyen d'une pince de contact (8) fabriquée en particulier sans précharge,
- dans laquelle la pince de contact (8) comprend une boucle de pince (12) ouverte, recourbée plusieurs fois et une jambe de contact (14) contactée avec les deux extrémités du trajet de courant (6a, 6b) en utilisant de la soudure, et une jambe de fixation (16) avec une extrémité de jambe (20) insérée dans une ouverture de carte de circuit imprimé (22), et
- dans laquelle une déformation est imprimée sur la pince de contact (8) sous l'effet de la génération d'une tension de précharge interne,
**caractérisée en ce**
- **que** la jambe de fixation (16) comprend une section de jambe (16b) recourbée en forme de S,
- **que** l'extrémité de jambe (20) de la jambe de fixation (16) est surdimensionnée par rapport à l'ouverture de la carte de circuit imprimé (22).

2. Assemblage électronique (2) selon la revendication 1,
**caractérisée en ce**
**que** l'extrémité de jambe (20) de la jambe de fixation (16) est enfoncée dans l'ouverture de la carte de circuit imprimé (22), lorsque la pince de contact (8) est préchargée par suite de sa déformation.

3. Assemblage électronique (2) selon la revendication 1 ou 2,
**caractérisée en ce**
**que** la boucle de pince (12) de la pince de contact (8) comprend, sur le côté de la boucle tourné vers la jambe de fixation (16), une section de boucle (12d) recourbée pour former un point destiné à la pliage (24d) pour la déformation de la pince de contact (8).

4. Assemblage électronique (2) selon l'une des revendications 1 à 3,
**caractérisée en ce**
**que** des sections en boucle recourbées (12a, 12e) de la boucle de pince (12) de la pince contact (8) et une section centrale en boucle (12b, 12c, 12d) avec au moins trois points de pliage (24a, 24b, 24c, 24d) sont formées entre la jambe de contact (14) et la jambe de fixation (16).

5. Assemblage électronique (2) selon la revendication 4,
**caractérisée en ce**
**que** la section centrale en boucle (12b, 12c, 12d) de la boucle de pince (12) a une largeur de section plus importante que la jambe de contact (14) et/ou la jambe de fixation (16).

6. Assemblage électronique (2) selon la revendication 4 ou 5,
**caractérisée en ce**
**qu'**une ouverture poinçonnée (26) est insérée dans la section centrale en boucle (12b, 12c, 12d) de la boucle de pince (12).

7. Assemblage électronique (2) selon la revendication 6,
**caractérisée en ce**
**que** l'ouverture du poinçonnée (26) s'étend sur au moins un des trois points de pliage (24b, 24c, 24d) de la section centrale en boucle (12b, 12c, 12d).

8. Assemblage électronique (2) selon l'une des revendications 1 à 7,
**caractérisée en ce**
**que** la jambe de fixation (16) comprend une section de contact (16a) reposant sur la carte de circuit imprimé (4), en particulier sur une pastille de soudure (18), et la section de jambe recourbée (16b) avec une largeur de section réduite par rapport à la section de contact (16a), dont l'extrémité de section forme l'extrémité de jambe (20) reposant dans l'ouverture de la carte de circuit imprimé (22).

9. Assemblage électronique (2) selon l'une des revendications 1 à 8,
**caractérisée en ce**
**que** la section recourbée en forme de S (16b) de la jambe de fixation (16) forme une surface de butée ou d'appui (16c) pour un outil d'activation (28) générant la déformation de la pince de contact (8).

10. Utilisation d'un assemblage électronique (2) selon l'une des revendications 1 à 9 pour un moteur électrique d'un système de réglage ou d'entraînement d'un véhicule automobile.
